# EUROPÄISCHE PATENTSCHRIFT

(11) **EP 2 629 107 B1**
(45) Veröffentlichungstag und Bekanntmachung des Hinweises auf die Patenterteilung: **25.09.2019**
(21) Anmeldenummer: 12155490.1
(22) Anmeldetag: 15.02.2012
(51) Int. Cl.: G01R 31/389, G01R 31/02, G01R 31/385

(54) **Widerstandsmesseinrichtung**
Resistance measuring device
Dispositif de mesure de résistance

(43) Veröffentlichungstag der Anmeldung: 21.08.2013
(73) Patentinhaber: Flextronics International Kft., Tab 8660 (HU)
(72) Erfinder: Covasala, Alexander, 73728 Esslingen (DE)
(74) Vertreter: Rupprecht, Kay

(56) Entgegenhaltungen:
- JP-A- 2008 189 010
- US-A1- 2001 034 541
- US-A1- 2010 088 050
- US-A1- 2010 228 416

## Beschreibung

Die vorliegende Erfindung betrifft eine Widerstandsmesseinrichtung gemäß dem Oberbegriff des Anspruchs 1.

Widerstandsmesseinrichtungen der hier angesprochenen Art sind grundsätzlich bekannt. Sie dienen zur Messung des Innenwiderstands von Energiespeichern, wie beispielsweise der Fahrzeugbatterie in einem Bordnetz eines Kraftfahrzeugs. Derartige Energiespeicher eines Kraftfahrzeugs werden üblicherweise auf ihre Funktionsweise hin überprüft, indem der Innenwiderstand des jeweiligen Energiespeichers geprüft wird. Dabei können Fehlfunktionen, insbesondere durch beschädigte Leitungen oder dergleichen, festgestellt werden, wenn der Innenwiderstand des jeweiligen Energiespeichers zulässige Grenzwerte über- oder unterschreitet. Insbesondere bei Start-/Stopp-Systemen in Kraftfahrzeugen und bei der hierzu benötigten Bordnetzstabilisierung ist die Messung des Innenwiderstands von Energiespeichern von besonderer Bedeutung. Verlässt der Innenwiderstand eines Energiespeichers einen vorgeschriebenen Grenzbereich, kann es nämlich zu einem Abschalten der Start-/Stopp-Funktion kommen. Bei den zu prüfenden Energiespeichern kann es sich um fest installierte oder ggf. auch um zuschaltbare Energiespeicher handeln. Notwendig ist die Innenwiderstandsmessung beispielsweise bei Spannungsquellen, wie beispielsweise Super CAP-Kondensatoren oder herkömmlichen Fahrzeugbatterien.

Besonders bei Batterien und vor allem SuperCAPs der neuesten Generation ist die Innenwiderstandsmessung problematisch, weil diese Energiespeicher auf besonders hohe Leistungsdichten ausgelegt sind, die einen möglichst geringen Innenwiderstand voraussetzen. Bei einem Energiespeicher, der einen sehr geringen Innenwiderstand aufweist, ist jedoch ein großer Stromfluss notwendig, um einen nennenswerten Spannungsabfall zu erzeugen. Um einen Spannungsabfall von 0,5 V an einer Spannungsquelle mit einem Innenwiderstand von 1 mΩ zu erzeugen, wird beispielsweise ein Stromfluss von 500 A benötigt. Die niederohmige Auslegung von Energiespeichern zwingt folglich zur Innenwiderstandsmessung im mΩ-Bereich, was kostenintensive und hochpräzise Messgeräte erfordert.

Eine weitere Problematik besteht darin, dass die Messung des Innenwiderstands während des Betriebs eines angeschlossenen Verbrauchers durch die Entladung des Energiespeichers nicht verfälscht werden darf. Hierzu ist eine besonders steile Stromrampe nötig, um eine zuverlässige Innenwiderstandsmessung zu ermöglichen. Damit die Entladung des Energiespeichers nicht mitgemessen wird, muss der Stromimpuls möglichst "hart" eingeschaltet werden und darüber hinaus "weich" abgeschaltet werden, um Spannungsüberhöhungen (Load Dump) durch einen plötzlichen Stromabriss zu vermeiden.

Aufgabe der vorliegenden Erfindung ist es daher, eine Widerstandsmesseinrichtung zur Messung des Innenwiderstands eines Energiespeichers zu schaffen, die flexibel einsetzbar ist und die auch bei niederohmig ausgelegten Energiespeichern zuverlässig den Innenwiderstand des Energiespeichers ohne eine Verfälschung des Ergebnisses durch die Entladung des Energiespeichers misst.

Zur Lösung der oben genannten Aufgabe wird eine Widerstandsmesseinrichtung mit den Merkmalen des Anspruchs 1 vorgeschlagen. Die Widerstandsmesseinrichtung dient zur lastunabhängigen Messung des Innenwiderstands eines Energiespeichers, insbesondere in einem Bordnetz eines Kraftfahrzeugs. Die Widerstandsmesseinrichtung zeichnet sich aus durch
- ein zu dem Energiespeicher parallel schaltbares Bauelement zum Erzeugen eines Stromimpulses;
- ein zwischen dem Energiespeicher und dem Bauelement anordenbares Schaltelement zum Kurzschließen des Energiespeichers über das Bauelement, und
- eine Messeinrichtung zum Messen eines Spannungsabfalls an dem Energiespeicher und zum Messen einer Stromdifferenz.

Ein wesentlicher Punkt der Erfindung liegt somit darin, dass die Widerstandsmesseinrichtung gemäß der Erfindung die Messung des Innenwiderstands eines Energiespeichers unabhängig von der angeschlossenen Last ermöglicht. Dabei kann der Zeitpunkt der Messung in vorteilhafter Weise beliebig gewählt werden. Durch das zusätzliche Bauelement, welches parallel zu dem Energiespeicher mittels eines Schaltelements zuschaltbar ist, kann ein definierter selbstabklingender Stromimpuls erzeugt werden, der zum einen das Erfordernis eines "harten" Einschaltens und zum anderen eines "weichen" Abschaltens erfüllt. Auf diese Weise wird vermieden, dass das Entladen des Energiespeichers in die Berechnung des Innenwiderstands des Energiespeichers fälschlicherweise mit einbezogen wird, und dass es zu unerwünschten Spannungserhöhungen kommt.

Besonders bevorzugt wird eine Widerstandsmesseinrichtung, bei der das (passive) Bauelement als Speicherelement, insbesondere in Form eines Kondensators, vorzugsweise als Elektrolytkondensator (Elko) ausgebildet ist. Es versteht sich, dass grundsätzlich auch andere Bauelemente zur Erzeugung des selbstabklingenden Stromimpulses erzeugt werden können, solange sie ein "hartes" Einschalten und ein "weiches" Ausschalten des Stromimpulses gewährleisten. Die Länge des Stromimpulses, der bei einem Schließen des Schaltelements und durch den erzeugten Kurzschluss zwischen dem Energiespeicher und dem Bauelement entsteht, hängt vom Gesamtwiderstand der Schaltung und von der Kapazität des parallel geschalteten Bauelements ab, sofern dieses als Kondensator ausgebildet ist. Das Schaltelement ist vorteilhafterweise als MOSFET ausgebildet. Denkbar sind jedoch auch andere Arten von Schaltelementen. Vorzugsweise wird das Schaltelement nur dann betätigt, wenn eine Innenwiderstandsmesseinrichtung des Energiespeichers durchgeführt werden soll. Das Schaltelement hat somit vorzugsweise ausschließlich die Funktion, die Durchführung einer Innenwiderstandsmesseinrichtung des Energiespeichers zu ermöglichen.

Die Messeinrichtung ist vorzugsweise über Messleitungen mit dem Energiespeicher und dem Bauelement verbunden und weist insbesondere einen Mikroprozessor zur Berechnung des Innenwiderstands des Energiespeichers auf. Der Innenwiderstand berechnet sich dabei durch den erfassten Spannungsabfall am Energiespeicher und durch eine Stromdifferenz. Die Stromdifferenz kann dabei über einen Strommesswiderstand erfasst werden, der vorzugsweise zwischen das Bauelement und den Energiespeicher schaltbar ist. Im Übrigen kann zu dem Bauelement ein Entladewiderstand parallel geschaltet sein.

Zur Lösung der oben genannten Aufgabe wird auch eine Energieversorgungseinrichtung, insbesondere in einem Bordnetz eines Kraftfahrzeugs, mit den Merkmalen des Anspruchs 8 vorgeschlagen. Die Energieversorgungseinrichtung weist einen Energiespeicher und eine Widerstandsmesseinrichtung gemäß der Erfindung auf. Der Energiespeicher kann einen oder mehrere Energiespeicherelemente, insbesondere in Form von sogenannten SuperCAP Kondensatoren aufweisen, die aus dem Stand der Technik hinreichend bekannt sind.

Wie gesagt ist es besonders vorteilhaft, wenn die Widerstandsmesseinrichtung nicht in den Lastpfad des Energiespeichers integriert ist, sondern unabhängig davon als modulares separates Element angeordnet ist, so dass ein permanenter Stromfluss in der Widerstandsmesseinrichtung vermieden wird. Dadurch reduziert sich die Verlustleistung in der Widerstandsmesseinrichtung erheblich. Weiterhin ergibt sich durch die vorliegende Erfindung eine geringe Belastung des Energiespeichers durch die Messwiderstandsmesseinrichtung gemäß der vorliegenden Erfindung. Im Übrigen kann ein Stromabriss, d.h. ein abruptes Ende des Stromflusses, beim Abschalten des Messstromimpulses vermieden werden. Spannungsüberhöhungen werden dadurch gänzlich vermieden. Darüber hinaus ergibt sich durch die vorliegende Erfindung der Vorteil, dass nur ein geringer Bauteileaufwand notwendig ist.

Relevante Widerstandsmesseinrichtungen sind in US 2010/228416 A1, in JP 2008 189010 A, in US 2001/034541 A1 und in US 2010/0880050 A1 offenbart.

Die Erfindung wird im Folgenden anhand der Zeichnung näher erläutert.

Es zeigen:
- Fig. 1: ein schematisches Blockschaltbild einer Energieversorgungseinrichtung mit einem Energiespeicher und einer Widerstandsmesseinrichtung gemäß der Erfindung, und
- Fig. 2: eine schematische Kennlinie der Strom- und Spannungsdifferenzen bei Durchführung einer erfindungsgemäßen Innenwiderstandsmessung eines Energiespeichers.

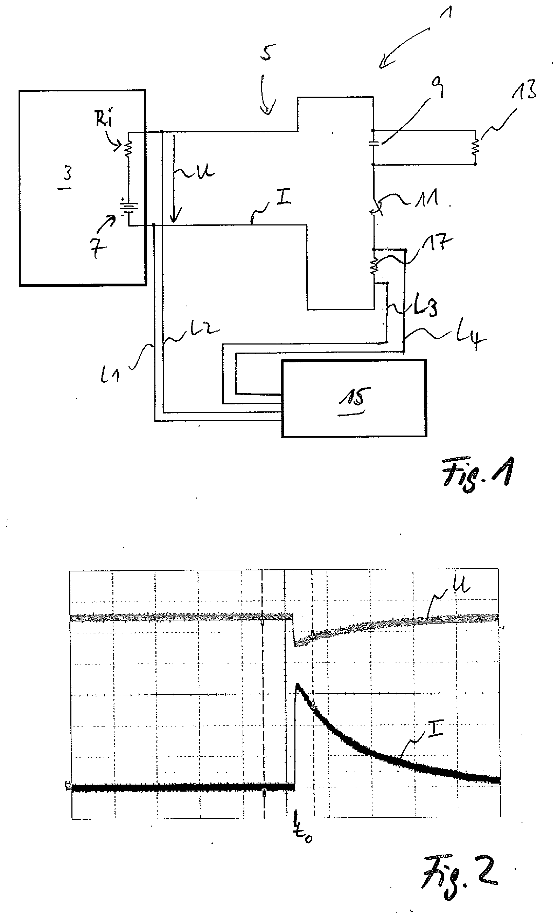

Fig. 1 zeigt eine schematische Darstellung einer Energieversorgungseinrichtung 1 mit einem Energiespeicher 3 und einer Widerstandsmesseinrichtung 5 gemäß der Erfindung. Der Energiespeicher 3 kann aus ein oder mehreren Energiespeicherelementen bestehen, beispielsweise aus mehreren SuperCAP Kondensatoren oder dergleichen Energiespeicherelementen. Alternativ kann es sich auch um eine herkömmliche Kraftfahrzeugbatterie oder dergleichen Energiespeicher handeln.

Der Energiespeicher 3 gemäß Fig. 1 hat einen Innenwiderstand Ri und eine Spannungsquelle 7, die über entsprechende Anschlüsse mit dem Bordnetz eines Kraftfahrzeugs verbunden sein kann. Die Widerstandsmesseinrichtung 5 ist an den Energiespeicher 3 angeschlossen. Vorzugsweise ist sie nicht im Leistungspfad des Energiespeichers zu dem Bordnetz integriert, sondern getrennt von diesem angeordnet. Auf diese Weise wird ein ständiger Stromfluss durch die Widerstandsmesseinrichtung 5 vermieden.

Die Widerstandsmesseinrichtung 5 umfasst ein vorzugsweise passives Bauelement 9, welches gemäß der Ausführungsform nach Fig. 1 als Kondensator und insbesondere als Elektrolytkondensator (Elko) ausgebildet ist. Das Bauelement 9 ist parallel zu dem Energiespeicher 3 angeordnet. Zwischen dem Energiespeicher 3 und dem Bauelement 9 ist ein Schaltelement 11 vorgesehen, über welches der Energiespeicher 3 mit dem Bauelement 9 kurzgeschlossen werden kann. Parallel zu dem Bauelement 9 kann noch ein Entladewiderstand 13 vorgesehen sein.

Weiterhin umfasst die Widerstandsmesseinrichtung 5 eine Messvorrichtung 15, die über Messleitungen L1, L2 und L3, L4 einerseits mit dem Energiespeicher 3 und andererseits mit dem Bauelement 9 verbunden ist. Die Messvorrichtung 15 dient zum Messen eines Spannungsabfalls ΔU. Hierzu sind die Messleitungen L1 und L2 an dem Energiespeicher 3 angeschlossen. Der Spannungsabfall an dem Energiespeicher kann genauer gemessen werden, wenn die Messleitungen L1, L2 möglichst nah an den Klemmen "+Pol" und "-Pol" angebracht wird. Dasselbe gilt für die im Folgenden erläuterte Strommessung, bei welcher ebenfalls eine Spannung möglichst genau gemessen werden soll. Ferner dient die Messvorrichtung 15 zum Messen einer Stromdifferenz ΔI. Hierzu ist die Messvorrichtung 15 über Messleitungen L3 und L4 mit einem Strommesswiderstand 17 verbunden, der zwischen den Energiespeicher 3 und das Bauelement 9 geschaltet ist. Die Messleitungen L3 und L4 sind möglichst nah an dem Strommesswiderstand 17 angeordnet, um den Spannungsabfall an dem Strommesswiderstand 17 mit einer hohen Genauigkeit erfassen zu können. Wenn das Schaltelement 11 geschlossen ist, fließt folglich ein Strom von dem Energiespeicher 3 über den Strommesswiderstand 17 zu dem Bauelement 9. Dieser Stromfluss wird durch den Strommesswiderstand 17 erfasst und über die Messleitung L3 an die Messvorrichtung 15 weitergeleitet.

Die Messvorrichtung 15 umfasst vorzugsweise einen Mikroprozessor, der auf der Grundlage des erfassten Spannungsabfalls ΔU und der erfassten Stromdifferenz ΔI den Innenwiderstand des Energiespeichers 3 nach der Formel Ri=ΔU/ΔI berechnet.

Die Funktionsweise der erfindungsgemäßen Widerstandsmesseinrichtung gemäß der Erfindung ist wie folgt:
Eine Messung des Innenwiderstands Ri des Energiespeichers 3 kann jederzeit unabhängig von einer angeschlossenen Last erfolgen. Hierzu wird das Schaltelement 11 geschlossen, so dass der Energiespeicher 3 über das Bauelement 9 kurzgeschlossen wird. Sofern das Bauelement 9, wie in der Fig. 1 dargestellt, als Kondensator ausgebildet ist, erzeugt die an dem Kondensator anliegende Spannung U einen selbstabklingenden Stromimpuls. Das elektrische Verhalten eines Kondensators im Gleichstromkreis bei Anlegen einer Spannung ist hinlänglich bekannt und soll daher nicht weiter ausgeführt werden. Entscheidend ist lediglich, dass das Zuschalten des Kondensators zu dem Energiespeicher einen Stromimpuls mit abklingendem Stromverlauf erzeugt, der für die Innenwiderstandsmessung herangezogen werden kann. Ein derartiger resultierender Verlauf der Spannung U an dem Energiespeicher 3 und des Stroms I zwischen dem Energiespeicher 3 und dem Bauelement 9 ist in der Fig. 2 schematisch dargestellt. Der Zeitpunkt t₀ deutet dabei den Zeitpunkt der Betätigung des Schaltelements 11 an, wenn also der Energiespeicher 3 mit dem Bauelement 9 kurzgeschlossen wird.

Die Fig. 2 macht deutlich, dass die Spannung U am parallel geschalteten Bauelement 9 kontinuierlich zunimmt, was aus dem Ladevorgang des Kondensators resultiert. Der Stromfluss I hingegen nimmt kontinuierlich ab oder klingt mit anderen Worten aus. Je mehr Ladung also transportiert wird, desto größer wird die Spannung am Kondensator. Nach dem ohmschen Gesetz nimmt der Strom infolgedessen ab. Auf diese Weise kann ein Stromabriss vermieden werden, der zu einer unerwünschten Spannungsüberhöhung (Load Dump) führen würde. Aus der Messung des Spannungsabfalls ΔU und einer entsprechenden Stromdifferenz ΔI aus den erfassen Messkurven U und I (s. Fig. 2) kann dann der Innenwiderstand Ri des Energiespeichers 3 bestimmt werden.

Es zeigt sich somit, dass die Widerstandsmesseinrichtung 5 gemäß der Erfindung auf einfache Art und Weise eine lastunabhängige Innenwiderstandsmesseinrichtung eines Energiespeichers 3 ermöglicht. Dies wird insbesondere dadurch bewerkstelligt, dass das Bauelement 9 als Kondensator ausgebildet ist, der naturgemäß einen definierten Stromimpuls beim Einschalten des Schaltelements 11 erzeugt.

Der Bauteileaufwand einer derartigen Schaltung ist gering und erzeugt nur eine geringe Verlustleistung. Weiterhin kann die Belastung des Energiespeichers 3 durch die Widerstandsmessung mit einer Widerstandsmesseinrichtung 5 gemäß der vorliegenden Erfindung gering gehalten werden.

Bei der vorliegenden erfindungsgemäßen Widerstandsmesseinrichtung 5 kommt der Stromfluss folglich nicht durch einen angeschlossenen Verbraucher zustande, sondern durch die Zuschaltung eines zusätzlichen, zu dem Energiespeicher 3 parallel geschalteten geeigneten Bauelements 9, welches den in Fig. 2 gezeigten selbstausklingenden Stromimpuls erzeugt. Ein passives Bauelement, welches diesen Effekt naturgemäß erzeugen kann, ist der Kondensator. Grundsätzlich können aber auch andere Bauteile, insbesondere auch aktive Bauteile zum Einsatz kommen, die ein derartiges vorteilhaftes Verhalten aufweisen.

Die Nachteile des Standes der Technik werden durch die Erfindung somit vermieden, indem ein selbstabklingender Strom und damit eine lastfreie Abschaltung bei der Innenwiderstandsmesseinrichtung gewährleistet ist. Somit können auch Energiespeicher, insbesondere Batterien oder SuperCAPs mit einer hohen Leistungsdichte zuverlässig auf ihren Innenwiderstand hin überprüft werden. Im Übrigen kann die Widerstandsmesseinrichtung 5 gemäß der vorliegenden Erfindung flexibel eingesetzt werden und insbesondere als zusätzliches, nachrüstbares, modulares Bauteil mit einem bestehenden Energiespeicher 3 zur Bildung einer erfindungsgemäßen Energieversorgungseinrichtung 1 verbunden werden.

### Bezuaszeichenliste

- 1: Energieversorgungseinrichtung
- 3: Energiespeicher
- 5: Widerstandsmesseinrichtung
- 7: Spannungsquelle
- 9: Bauelement
- 11: Schaltelement
- 13: Entladewiderstand
- 15: Messvorrichtung
- 17: Strommesswiderstand
- Ri: Innenwiderstand
- L1: Messleitung
- L2: Messleitung
- L3: Messleitung
- L4: Messleitung
- U: Spannung
- I: Strom
- ΔU: Spannungsabfall
- ΔI: Stromdifferenz

## Patentansprüche

1. Widerstandsmesseinrichtung (5) zur lastunabhängigen Messung des Innenwiderstands (Ri) eines Energiespeichers (3), insbesondere in einem Bordnetz eines Kraftfahrzeugs, aufweisend:
- ein zu dem Energiespeicher (3) parallel schaltbares Bauelement (9) zum Erzeugen eines Stromimpulses, wobei das Bauelement (9) als passives Energiespeicherelement ausgebildet ist;
- ein zwischen dem Energiespeicher (3) und dem Bauelement (9) anordenbares Schaltelement (11) zum Kurzschließen des Energiespeichers (3) über das Bauelement (9), und
- eine Messvorrichtung (15) zum Messen eines Spannungsabfalls (ΔU) an dem Energiespeicher (3) und zum Messen einer Stromdifferenz (ΔI),
**dadurch gekennzeichnet, dass**
die Widerstandsmesseinrichtung (5) als getrennt von dem Leistungspfad des Energiespeichers (3) anordenbares nachrüstbares und modulares Bauteil ausgebildet ist.

2. Widerstandsmesseinrichtung nach Anspruch 1,
**dadurch gekennzeichnet, dass**
das Bauelement (9) als Kondensator, vorzugsweise als Elektrolytkondensator, ausgebildet ist.

3. Widerstandsmesseinrichtung nach einem der vorhergehenden Ansprüche,
**dadurch gekennzeichnet, dass**
das Schaltelement (11) als MOSFET ausgebildet ist.

4. Widerstandsmesseinrichtung nach einem der vorhergehenden Ansprüche,
**dadurch gekennzeichnet, dass**
die Messvorrichtung (15) einen Mikroprozessor zur Bestimmung des Innenwiderstands (Ri) des Energiespeichers (3) umfasst.

5. Widerstandsmesseinrichtung nach einem der vorhergehenden Ansprüche,
**dadurch gekennzeichnet, dass**
die Messvorrichtung (15) über Messleitungen (L1, L2, L3, L4) mit dem Energiespeicher (3) und dem Bauelement (9) verbunden ist.

6. Widerstandsmesseinrichtung nach einem der vorhergehenden Ansprüche,
**dadurch gekennzeichnet, dass**
ein mit der Messvorrichtung (15) in Verbindung stehender Strommesswiderstand (17) zwischen das Bauelement (9) und den Energiespeicher (3) schaltbar ist.

7. Widerstandsmesseinrichtung nach einem der vorhergehenden Ansprüche,
**dadurch gekennzeichnet, dass**
ein Entladewiderstand (13) parallel zu dem Bauelement (9) geschaltet ist.

8. Energieversorgungseinrichtung (1), insbesondere in einem Bordnetz eines Kraftfahrzeugs, aufweisend einen Energiespeicher (3) sowie eine Widerstandsmesseinrichtung (5) nach einem der Ansprüche 1 bis 7.

9. Energieversorgungseinrichtung nach Anspruch 8,
**dadurch gekennzeichnet, dass**
der Energiespeicher (3) mindestens einen, vorzugsweise sechs SuperCAP-Kondensatoren aufweist.

## Claims

1. A resistance measurement device (5) for the load-independent measurement of the internal resistance (Ri) of an energy storage (3), in particular in an electrical system of a motor vehicle, comprising:
- a component (9) connectable in parallel to the energy storage (3) for generating a current pulse, wherein the component (9) is designed as a passive energy storage element;
- a switch element (11) arrangeable between the energy storage (3) and the component (9) for shorting the energy storage (3) via the component (9), and
- a measuring device (15) for measuring a voltage drop (ΔU) of the energy storage (3) and for measuring a current difference (ΔI),
**characterized in that**
the resistance measurement device (5) is configured as a retrofittable and modular component able to arranged separate from the power path of the energy storage (3).

2. The resistance measurement device according to claim 1,
**characterized in that**
the component (9) is designed as a capacitor, preferably an electrolytic capacitor.

3. The resistance measurement device according to one of the preceding claims,
**characterized in that**
the switch element (11) is designed as a MOSFET.

4. The resistance measurement device according to one of the preceding claims,
**characterized in that**
the measuring device (15) comprises a microprocessor for determining the internal resistance (Ri) of the energy storage (3).

5. The resistance measurement device according to one of the preceding claims,
**characterized in that**
the measuring device (15) is connected to the energy storage (3) and the component (9) via measuring leads (L1, L2, L3, L4).

6. The resistance measurement device according to one of the preceding claims,
**characterized in that**
a current-sensing resistor (17) connected to the measuring device (15) is connectable between the component (9) and the energy storage (3).

7. The resistance measurement device according to one of the preceding claims,
**characterized in that**
a discharge resistor (13) is connected in parallel with the component (9).

8. A power supply device (1), in particular in an electrical system of a motor vehicle, comprising an energy storage (3) as well as a resistance measurement device (5) in accordance with one of claims 1 to 7.

9. The power supply device according to claims 8
**characterized in that**
the energy storage (3) comprises at least one, preferably six SuperCap capacitors.

## Revendications

1. Dispositif de mesure de résistance (5) destiné à la mesure indépendante de la charge de la résistance intérieure (Ri) d'un accumulateur d'énergie (3), en particulier dans un réseau à bord d'un véhicule automobile, comprenant :
- un composant (9) susceptible d'être branché en parallèle à l'accumulateur d'énergie (3) afin de générer une impulsion de courant, ledit composant (9) étant réalisé sous forme d'élément accumulateur d'énergie passif ;
- un élément de commutation (11) susceptible d'être agencé entre l'accumulateur d'énergie (3) et le composant (9) pour mettre en court-circuit l'accumulateur d'énergie (3) via le composant (9), et
- un dispositif de mesure (15) pour mesurer une chute de tension (ΔU) au niveau de l'accumulateur d'énergie (3) et pour mesurer une différence de courant (ΔI),
**caractérisé en ce que**
le dispositif de mesure de résistance (5) est réalisé sous forme d'un composant modulaire capable d'être équipé a posteriori et destiné à être agencé séparément du trajet de puissance de l'accumulateur d'énergie (3).

2. Dispositif de mesure de résistance selon la revendication 1,
**caractérisé en ce que** le composant (9) est réalisé sous forme de condensateur, de préférence sous forme de condensateur électrolytique.

3. Dispositif de mesure de résistance selon l'une des revendications précédentes,
**caractérisé en ce que** l'élément de commutation (11) est réalisé sous forme de MOSFET.

4. Dispositif de mesure de résistance selon l'une des revendications précédentes,
**caractérisé en ce que** le dispositif de mesure (15) inclut un microprocesseur pour la détermination de la résistance intérieure (Ri) de l'accumulateur d'énergie (3).

5. Dispositif de mesure de résistance selon l'une des revendications précédentes,
**caractérisé en ce que** le dispositif de mesure (15) est connecté à l'accumulateur d'énergie (3) et au composant (9) via des lignes de mesure (L1, L2, L3, L4).

6. Dispositif de mesure de résistance selon l'une des revendications précédentes,
**caractérisé en ce qu'**il est prévu une résistance de mesure de courant (17), reliée au dispositif de mesure (15), susceptible d'être branchée entre le composant (9) et l'accumulateur d'énergie (3).

7. Dispositif de mesure de résistance selon l'une des revendications précédentes,
**caractérisé en ce qu'**une résistance de décharge (13) est branchée parallèlement au composant (9).

8. Système d'alimentation en énergie (un), en particulier dans un réseau à bord d'un véhicule automobile, comprenant un accumulateur d'énergie (3) ainsi qu'un dispositif de mesure de résistance (5) selon l'une des revendications 1 à 7.

9. Système d'alimentation en énergie selon la revendication 8, **caractérisé en ce que** l'accumulateur d'énergie (3) comprend au moins un et de préférence six condensateurs du type "superCAP".
